**Europäisches Patentamt**

**European Patent Office**

**Office européen des brevets**

(11) Veröffentlichungsnummer: **0 296 427 B1**

(12) **EUROPÄISCHE PATENTSCHRIFT**

(45) Veröffentlichungstag der Patentschrift: **11.11.92**

(21) Anmeldenummer: **88109285.2**

(22) Anmeldetag: **10.06.88**

(51) Int. Cl.⁵: **H01S 3/103**, H01S 3/133, B23K 26/02, H04B 10/08

(54) **Laserdiodensender mit Schutzschaltung.**

(30) Priorität: **23.06.87 DE 3720753**

(43) Veröffentlichungstag der Anmeldung:
**28.12.88 Patentblatt 88/52**

(45) Bekanntmachung des Hinweises auf die
Patenterteilung:
**11.11.92 Patentblatt 92/46**

(84) Benannte Vertragsstaaten:
**BE DE FR GB IT**

(56) Entgegenhaltungen:
**EP-A- 0 044 019**
**EP-A- 0 141 191**
**EP-A- 0 141 192**
**GB-A- 2 175 437**

(73) Patentinhaber: **SIEMENS AKTIENGESELL-
SCHAFT
Wittelsbacherplatz 2
W-8000 München 2(DE)**

(72) Erfinder: **Dömer, Josef, Dipl.-Ing.
Flossgatter 18
W-8021 Hohenschäftlarn(DE)**

**Beschreibung**

Die Erfindung betrifft einen Laserdiodensender entsprechend dem Oberbegriff des Anspruchs 1.

Um eine Personengefährdung durch Laserlicht bei optischen Übertragungsstrecken zu verhindern, ist es üblich, den Laserdiodensender mit einer von der Regelung des Laserstroms unabhängigen Abschalteinrichtung zu betreiben. Diese spricht an, wenn der Lichtwellenleiter zum Empfänger unterbrochen wird und damit die Personengefährdung durch die Möglichkeit, in den das Sendelicht führenden Lichtwellenleiter zu schauen, gegeben ist. Um das automatische Abschalten zu erreichen, ist eine Rückkanal von der Empfangsstation zur Sendestation erforderlich. Bei Zweirichtungsbetrieb wird dieser Rückkanal üblicherweise von der entgegengesetzten Übertragungsrichtung gebildet.

Bei einseitig gerichtetem Betrieb, wie er zum Beispiel bei Videoübertragungen üblich ist, muß entweder der zusätzliche Aufwand für die Rückrichtung in Kauf genommen werden oder es muß durch Sondermaßnahmen ein separater Rückkanal auf elektrischem Wege geschaffen werden. Da in diesen Fällen ein erhöhter Aufwand auftritt, versucht man die Personengefährdung dadurch zu umgehen, daß der Laserdiodensender mit so geringer Ausgangsleistung betrieben wird, daß sich keine Personenschäden durch das Laserlicht ergeben können. Nun kann aber durch einen Fehler in der Ansteuerelektronik für den Laserdiodensender oder in dessen Regelschleife der Arbeitspunkt des Laserdiodensenders soweit verschoben werden, daß der vorgesehene Grenzwert für die optische Ausgangsleistung überschritten und damit eine Personengefährdung möglich wird. Für die Regelung von Laserdiodensendern mit einem, über eine Anschlußfaser (Pigtail) optisch angekoppelten Lichtwellenleiter ist es bereits bekannt, die Anschlußfaser mit einem optischen Abzweiger mit nachgeschalteter Monitorfotodiode zu kombinieren und an dieser einen elektronischen Vergleicher anzuschließen.

Die Aufgabe bei der vorliegenden Erfindung besteht also darin, eine wenig aufwendige Möglichkeit zu finden, einen Laserdiodensender bei Überschreiten eines voreingestellten Grenzwertes für die abgegebene Lichtleistung automatisch abzuschalten.

Erfindungsgemäß wird die Aufgabe bei einem Laserdiodensender der eingangs erwähnten Art durch die im Kennzeichen des Patentanspruchs 1 angegebenen Maßnahmen gelöst. Von besonderem Vorteil ist dabei, daß die vorgeschlagenen Maßnahmen nicht nur als Lasersicherheitsabschaltung bei Personengefährdung wirksam sind, sondern gleichzeitig auch Schutzmaßnahmen vor der Zerstörung des Laserdiodensenders bei Überschreiten der zulässigen Lichtleistungswerte darstellen. Derartige kritische Verschiebungen des Arbeitspunktes der Laserdiode können beispielsweise auch durch Eindringen von Feuchtigkeit in den Laserdiodensender oder als Auswirkungen größerer elektromagnetischer Impulse auftreten. Wenig aufwendige und damit zweckmäßige Ausbildungen und Weiterbildungen des erfindungsgemäßen Laserdiodensenders sind in den Patentansprüchen 2 bis 5 näher beschrieben.

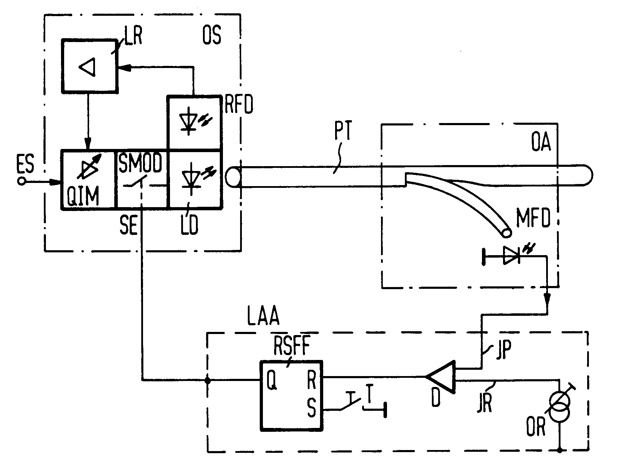

Die Erfindung wird im Folgenden anhand der Zeichnung näher erläutert. Die Zeichnung zeigt ein Prinzipschaltbild des erfindungsgemäßen Laserdiodensenders mit dem optischen Sender OS, dem optischen Abzweiger OA und der Laserabschaltautomatik LAA.

Der optische Sender OS ist an einen Eingang ES angeschlossen, über den ein Eingangssignal zu einer Modulationsstrom- und Vorstromquelle QIM gelangt, deren Ausgang über einen gesteuerten Schalter SMOD mit einer Laserdiode LD als optischer Sender verbunden ist. An die Laserdiode LD optisch angekoppelt, ist die als "Pigtail" bekannte Anschlußfaser PT, außerdem ist eine Regelphotodiode RFD mit der Laserdiode optisch verbunden. Das Ausgangssignal der Regelfotodiode dient als Eingangssignal für die Laserregelung LR, die in der aus den DE-OS 28 41 433 und 28 47 182 bekannten Weise den Arbeitspunkt der Laserdiode LD einregelt.

Aus dem von der Laserdiode LD an die Anschlußfaser PT abgegebenen Nutzlicht wird mittels des optischen Abzweigers OA ein vergleichsweise sehr geringer Teil von 1% bis 2% ausgekoppelt und an eine Monitorfotodiode MFD weitergeleitet. Der optische Abzweiger ist dabei mittels eines sogenannten Kernanschliffs realisiert, ein Teil der Anschlußfaser ist so abgeschliffen, daß eine kleine Querschnittsfläche der Anschlußfaser freiliegt und dort über eine vergleichsweise dünne Faser ein Teil des Nutzlichtes abgekoppelt werden kann. Dieses Verfahren zur optischen Abzweigung beruht also auf den unterschiedlichen Abmessungen der freigelegten Querschnittsfläche und der verbliebenen Querschnittsfläche, so daß die erzielbare Genauigkeit hinsichtlich des Auskoppelfaktors vergleichsweise gering ist. Bei einer Laserregelung stört diese geringe Genauigkeit, da sie sich unmittelbar auf die Genauigkeit der Arbeitspunkteinstellung auswirkt. Bei der Lasersicherheitsabschaltung ist die geringe Genauigkeit unkritisch, da lediglich sichergestellt sein muß, daß im Bereiche eines Grenzwertes eine Abschaltung erfolgt.

Der Ausgangstrom IP der Monitorfotodiode gelangt zu einem Eingang eines in der Laserabschaltautomatik LAA enthaltenen Differenzverstärkers D. Dem anderen Eingang dieses Differenzverstärkers wird ein Referenzstrom IR zugeführt, der von einer einstellbaren Referenzstromquelle QR stammt und dessen Wert zusammen mit dem Auskoppelfaktor des optischen Abzweigers und dem opto-elektrischen Wirkungsgrad der Monitorfotodiode den Grenzwert der abgegebenen Lichtleistung der Laserdiode LD definiert. Das Ausgangssignal des Differenzverstärkers D wird dem R-Eingang eines RS-Flip-Flops RSFF zugeführt, der S-Eingang dieses Flip-Flops ist über einen handbetätigbaren Taster T mit Bezugspotential verbindbar. Bei einem bestimmten Wert des Differenzverstärkerausgangssignals kippt das RS-Flip-Flop, so daß an dessen nichtinvertierenden Ausgang Q der logische Eins-Pegel erscheint. Da der nichtinvertierende Ausgang Q des RS-Flip-Flops mit einem Steuereingang SE des gesteuerten Schalters SMOD verbunden ist, wirkt sich der wechselnde logische Pegel am Q-Ausgang des RS-Flip-Flops auf den gesteuerten Schalter aus, der die Verbindung zwischen der Vorstrom- und Modulationsstromquelle QIM und der Laserdiode LD entsprechend dem logischen Pegel an seinem Steuereingang ein- und abschaltet.

Mit dem Abschalten der Laserdiode LD geht deren abgegebene Lichtleistung auf Null zurück, so daß der von der Monitorfotodiode abgegebene Strom IP kleiner als der Referenzstrom IR wird. Damit kehrt sich die Polarität des vom Differenzverstärker abgegebenen Signals um, da das RS-Flip-Flop aber nicht auf diese veränderte Polarität reagieren kann, kann in diesem Falle über die Taste T der logische Pegel am Ausgang des RS-Flip-Flops umgeschaltet und die Laserdiode LD wieder eingeschaltet werden.

Es ist erkennbar, daß der erfindungsgemäße Laserdiodensender keine hohen Anforderungen hinsichtlich der Genauigkeit der einzelnen Bauteile stellt, außerdem können die Regelschaltungen unverändert übernommen werden, da keinerlei Eingriff in diese erfolgt, so daß vorhandene integrierte Schaltungen weiterverwendet werden können.

## Patentansprüche

1.  Laserdiodensender mit einem, über eine Anschlußfaser (PT) optisch an eine Laserdiode (LD) angekoppelten Lichtwellenleiter, wobei die Anschlußfaser mit einem optischen Abzweiger (OA) mit nachgeschalteter Monitorfotodiode (MFD) kombiniert ist und an diese ein elektronischer Vergleicher (D) angeschlossen ist, **dadurch gekennzeichnet,** daß der elektronische Vergleicher (D) bei Überschreiten eines voreingestellten Grenzwertes durch das von der Monitorfotodiode (MFD) erzeugte elektrische Signal ein Schaltsignal an einen gesteuerten Schalter (SMOD) abgibt und durch diesen wahlweise der Modulationsstrom und/oder der Vorstrom der Laserdiode (LD) abgeschaltet wird.

2.  Laserdiodensender nach Anspruch 1, **dadurch gekennzeichnet,** daß ein Anschluß der Monitorfotodiode (MFD) mit dem einen Eingangsanschluß eines Differenzverstärkers (D) verbunden ist, daß der andere Eingangsanschluß dieses Differenzverstärkers mit einer Quelle (QR) für einen einstellbaren Referenzstrom verbunden ist, daß der Ausgang des Differenzverstärkers (D) mit dem R-Eingang eines RS-Flip-Flops (RSFF) verbunden ist, daß der S-Eingang des RS-Flip-Flops über eine handbetätigte Taste (T) mit Bezugspotential verbunden ist und daß der nichtinvertierende Ausgang (Q) des RS-Flip-Flops (RSFF) mit dem Steueranschluß der Schalteinrichtung (SMOD) verbunden ist, über die der Laserdiodensender an eine Vorstrom und/oder Modulationsstromquelle (QIM) angeschlossen ist.

3.  Laserdiodensender nach Ansprüchen 1 oder 2, **dadurch gekennzeichnet,** daß der einstellbare Referenzstrom und damit der eingestellte Grenzwert des von der Monitorfotodiode (MFD) erzeugten elektrischen Signals im Hinblick auf eine mögliche Personengefährdung beim Bruch des an den Laserdiodensender angeschlossenen Lichtwellenleiters bemessen ist.

4.  Laserdiodensender nach Ansprüchen 1 oder 2, **dadurch gekennzeichnet,** daß der Referenzstrom und damit der voreingestellte Grenzwert des von der Monitorfotodiode (MFD) erzeugten elektrischen Signals im Hinblick auf die zulässige Grenzbelastung des Laserdiodensenders bemessen ist.

5.  Laserdiodensender nach Anspruch 1, **dadurch gekennzeichnet,** daß die Abschaltung des Modulationsstroms und/oder des Vorstroms nur für eine vorgegebene Zeit erfolgt und daß anschließend der Laserdiodensender periodisch für vergleichsweise kurze Zeitabschnitte eingeschaltet wird.

## Claims

1.  Laser diode transmitter comprising an optical waveguide which is optically coupled via a pigtail (PT) to a laser diode (LD), the pigtail being combined with an optical branching device (OA) having a downstream monitor photodiode (MFD) and an electronic comparator (D) being connected to the latter, characterised in that when a preset limit value is exceeded by the electrical signal generated by the monitor photodiode (MDF) the electronic comparator (D) emits a switching signal to a controlled switch (SMOD) and the modulation current and/or the bias current of the laser diode (LD) is optionally disconnected by said switch.

2. Laser diode transmitter according to Claim 1, characterised in that a terminal of the monitor photodiode (MFD) is connected to one input terminal of a differential amplifier (D), in that the other input terminal of said differential amplifier is connected to a source (QR) of an adjustable reference current, in that the output of the differential amplifier (D) is connected to the R input of a RS flip-flop (RSFF), in that the S input of the RS flip-flop is connected to a reference potential via a manually operated key (T), and in that the non-inverting output (Q) of the RS flip-flop (RSFF) is connected to the control terminal of the switching device (SMOD), via which the laser diode transmitter is connected to a bias current and/or modulation current source (QIM).

3. Laser diode transmitter according to Claim 1 or 2, characterised in that the adjustable reference current, and thus the set limit value of the electrical signal generated by the monitor photodiode (MFD), are dimensioned in view of possible risk to personnel in the event of breakage of the optical waveguide connected to the laser diode transmitter.

4. Laser diode transmitter according to Claim 1 or 2, characterised in that the reference current, and thus the preset limit value of the electrical signal generated by the monitor photodiode (MFD), are dimensioned in view of the permissible limit load of the laser diode transmitter.

5. Laser diode transmitter according to Claim 1, characterised in that the disconnection of the modulation current and/or of the bias current takes place only for a predetermined time, and in that subsequently the laser diode transmitter is periodically switched on for comparatively short time intervals.

**Revendications**

1. Émetteur à diode laser comportant un guide d'ondes optiques couplé optiquement à une diode laser (LD) par l'intemédiaire d'une fibre de raccordement (PT), et dans lequel la fibre de raccordement est combinée à un dispositif de dérivation optique (OA) en aval duquel est branchée une photodiode de contrôle (MFD) et un comparateur électronique (D) est raccordé à cette diode,
caractérisé par le fait
que lors du dépassement d'une valeur limite préréglée, par le signal électrique produit par la photodiode de contrôle (MFD), le comparateur électronique (D) envoie un signal de commutation à un interrupteur commandé (SMOD) et le courant de modulation et/ou le courant de prédécharge de la diode laser (LD) sont interrompus à volonté par cette interrupteur.

2. Émetteur à diode laser suivant la revendication 1, caractérisé par le fait
qu'une borne de la photodiode de contrôle (MFD) est raccordée à une borne d'entrée d'un amplificateur différentiel (D), que l'autre borne d'entrée de cet amplificateur différentiel est raccordée à une source (QR) délivrant un courant de référence réglable,
que la sortie de l'amplificateur différentiel (D) est raccordée à l'entrée R d'une bascule bistable de type RS (RSFF), que l'entrée S de la bascule bistable de type RS est raccordée au potentiel de référence par l'intermédiaire d'une touche (T) à actionnement manuel, et
que la sortie non inverseuse (Q) de la bascule bistable de type RS (RSFF) est raccordée à la borne de commande du dispositif de coupure (SMOD), par l'intermédiaire duquel l'émetteur à diode laser est relié à une source d'un courant de prédécharge et/ou à une source de courant de modulation (QIM).

3. Émetteur à diode laser suivant la revendication 1 ou 2, caractérisé par le fait que le courant de référence réglable et par conséquent la valeur limite réglée du signal électrique produit par la photodiode de contrôle (MFD), sont choisis en fonction d'un risque possible pour les personnes dans le cas d'une rupture du guide d'ondes optiques raccordé à l'émetteur à diode laser.

4. Émetteur à diode laser suivant la revendication 1 ou 2, caractérisé par le fait que le courant de référence et par conséquent la valeur limite préréglée du signal électrique produit par la photodiode de contrôle (MFD), sont choisis en fonction de la charge limite admissible de l'émetteur à diode laser.

5. Émetteur à diode laser suivant la revendication 1, caractérisé par le fait que la coupure du courant de modulation et/ou du courant de prédécharge est réalisée uniquement pendant un intervalle de temps prédéterminé et qu'ensuite, l'émetteur à diode laser est branché périodiquement pendant des intervalles de temps relativement brefs.